# EUROPEAN PATENT APPLICATION

(11) **EP 4 586 317 A1**
(43) Date of publication of application: **16.07.2025**
(21) Application number: 24194367.9
(22) Date of filing: 13.08.2024
(51) Int. Cl.: H01L 25/07, H01L 23/051

(54) **A POWER SEMICONDUCTOR DEVICE FOR AN INVERTER SYSTEM OF AN ELECTRIC VEHICLE**

(71) Applicant: Volvo Car Corporation, 405 31 Göteborg (SE)
(72) Inventor: ZHANG, Chi, 405 31 Göteborg (SE)
(74) Representative: Maiwald GmbH

(57) **Abstract**

The disclosure relates to a power semiconductor device (10) for an inverter system (70) of an electric vehicle (100), the power semiconductor device (10) comprising a first semiconductor chip (11) and a second semiconductor chip (12), wherein a drain side (11A) of the first semiconductor chip (11) is electrically connected to a source side (12B) of the second semiconductor chip (12), and wherein the drain side (11A) of the first semiconductor chip (11) and the source side (12B) of the second semiconductor chip (11) are arranged opposite of a source side (11B) of the first semiconductor chip (11) and a drain side (12A) of the second semiconductor chip (12).

## Description

### TECHNICAL FIELD

The present disclosure relates to a power semiconductor device for an inverter system of an electric vehicle.

### BACKGROUND

In a power semiconductor device, an arrangement of semiconductor chips on a printed circuit board, PCB, may form a current commutation loop. In known designs of power semiconductor devices, lengthy current commutation loops cause significant switching losses and slower switching in the power semiconductor devices.

### SUMMARY

The problem is at least partially solved or alleviated by the subject matter of the independent claims of the present disclosure, wherein further examples are incorporated in the dependent claims.

According to a first aspect, there may be provided a power semiconductor device for an inverter system of an electric vehicle, the power semiconductor device comprising a first semiconductor chip and a second semiconductor chip, wherein a drain side of the first semiconductor chip is electrically connected to a source side of the second semiconductor chip, and wherein the drain side of the first semiconductor chip and the source side of the second semiconductor chip are arranged opposite of a source side of the first semiconductor and a drain side of the second semiconductor device.

In the power semiconductor device, the two power semiconductor chips may be connected to one another. The two semiconductor chips may be arranged such that the drain side of the first semiconductor chip may be on the same side of the power semiconductor device as the source side of the second semiconductor chip. In other words, the drain side of the first semiconductor chip and the source side of the second semiconductor chip may be arranged opposite of the source side of the first semiconductor and the drain side of the second semiconductor device. The drain side of the first semiconductor chip and the source side of the second semiconductor chip may be arranged at a same height or width of the power semiconductor device. The drain side of the first semiconductor chip and the source side of the second semiconductor chip may be connected to one another. The arrangement of two semiconductor chips may shorten a connection path between the source side of the first semiconductor chip and the drain side of the second semiconductor chip. The semiconductor device comprising at least two semiconductor chips may form a current commutation loop. The commutation current loop may be a path that a current follow during the semiconductor chips transitions from an on-state to an off-state. In an example, the commutation current loop may follow a path starting from the drain side of the second semiconductor chip, then proceed through the source side of the second semiconductor chip, followed by the drain side of the first semiconductor chip, and finally end at the source side of the first semiconductor chip. The arrangement of the power semiconductor device as described herein may shorten the commutation current loop because the drain side of the first semiconductor chip may be arranged towards or facing the same direction as the source side of the second semiconductor chip, and they may be electrically connected to one another. In other words, the path between the source side of the first semiconductor chip and the drain side of the second semiconductor chip may shorten as they are arranged at the same side of the power semiconductor device. Specifically, the invention is based on the finding that the length of the current commutation loop is inter alia dependent on the arrangement of the power semiconductor chips, e.g., on a PCB. The arrangement of the two power semiconductor chips on the PCB in a same direction, which is typically used, causes a long current commutation loop. However, with the suggested orientation of the power semiconductor chips in the power semiconductor device as suggested herein, the commutation current loop may be significantly shortened.

The arrangement as described herein, due to the shortened commutation current loop, may provide faster switching performance of the semiconductor chips and reduce switching losses of the power semiconductor device. The faster switching performance of the semiconductor chips may be requiring less switching time of the semiconductor chips. Accordingly, the reduced switching time may increase a switching speed of the semiconductor chips. Accordingly, the reduced switching losses of the power semiconductor device may be achieved by providing a shorter commutation current loop. Furthermore, the shorter commutation current loop may at least reduce a parasitic inductance, a lower voltage overshoot and/or improve electromagnetic interface, EMI, performance.

The power semiconductor device may comprise two or more semiconductor chips, which may be connected to one another. In an example, the power semiconductor device may comprise a third and/or fourth semiconductor chip. A drain side of the third semiconductor chip may be connected to a source side of the fourth semiconductor chip. The third and the fourth semiconductor chips may be arranged in parallel to the first and the second semiconductor chips. In other words, a source side of the third semiconductor chip may be connected to the source side of the first semiconductor chip and a drain side of the fourth semiconductor chip may be connected to the drain side of the second semiconductor chip. The semiconductor chips as described herein may be power semiconductor chips.

Generally, a power semiconductor device may be an electronic device that controls and manages the flow of electrical power in circuits. It may be capable of handling high voltages and currents and may be used in applications such as power conversion, regulation, and switching. The power semiconductor device may be of any type, including but not limited to inverter systems, converter systems and similar. The power semiconductor device may comprise one or more semiconductor chips. In an example, the one or more semiconductor chips may comprise three terminals including gate, drain and source. The one or more semiconductor chip may have two sides or, in other words, a two-side form, including a drain side and a source side. The gate terminal may control operation of the semiconductor chip. In particular, the gate terminal may control switching the semiconductor chip between its on (conducting) and off (non-conducting) states. The power semiconductor device of an inverter system of an electric vehicle may be connected to one or more heatsink. The power semiconductor device may be used for any type of application, including but not limited to electric vehicles. An electric vehicle is any vehicle that has an electric motor in its drive system and includes, for example, hybrid electric vehicles and fuel cell vehicles. Further, generally, the vehicle may be of any type, including but not limited to cars, trucks, and similar.

According to an example, the power semiconductor device further may comprise one or more capacitors electrically connected in parallel to both semiconductor chips.

One pole of the one or more capacitors may be connected to a negative terminal of a power source and another pole of the one or more capacitors may be connected to a positive terminal of the power source. In an example, there may be provided one capacitor electrically connected in parallel to both semiconductor chips. One pole of the one capacitor may be connected to the negative terminal of the power source and another pole of the capacitor may be connected to the positive terminal of the power source. In another example, there may be provided two capacitors connected to one another and electrically connected in parallel to both semiconductor chips. One pole of a first capacitor may be connected to a pole of a second capacitor. The other pole of the first capacitor may be connected to the negative terminal of the power source and another pole of the second capacitor may be connected to the positive terminal of the power source. In another example, each of the two capacitors may be connected in parallel to one of the semiconductor chips. In other words, one of the two capacitors, particularly, the first capacitor may be connected in parallel to the first semiconductor chip and other one of the two capacitor, particularly, the second capacitor may be connected in parallel to the second semiconductor chip. The one or more capacitors electrically connected in parallel to the semiconductor chips may be used to smooth out the DC voltage from an input power source. These capacitors may maintain a stable DC voltage level for the operation of the power semiconductor device and may serve as short-term energy storage. During the operation of the power semiconductor device, the capacitors may source energy to the semiconductor chips, ensuring smooth transitions between on and off states and reducing voltage spikes. They may also reduce stress on the semiconductor chips by providing instantaneous current when needed. Additionally, the capacitors may decouple the effect of inductance from the input DC voltage and reduce leakage inductance of the power semiconductor device. The switching time of the semiconductor chips and switching losses may be reduced. Using these capacitors may increase stability and reduce losses in the power semiconductor device. The capacitors may be, but are not limited to, electrolytic or film capacitors.

According to an example, the one or more capacitors may be electrically connected between a source side of the first semiconductor chip and a drain side of the second semiconductor chip.

The one pole of the one or more capacitors may be connected to the source side of the first semiconductor chip and the other pole of the one or more capacitors may be connected to the drain side of the second semiconductor chip. In an example, there may be provided one capacitor electrically connected between the source side of the first semiconductor chip and the drain side of the second semiconductor chip. One pole of the capacitor may be connected to the source side of the first semiconductor chip and another pole of the capacitor may be connected to the drain side of the second semiconductor chip. In another example, there may be provided two capacitors electrically connected to the source side of the first semiconductor chip and to the drain side of the second semiconductor chip. One pole of a first capacitor may be connected to a pole of a second capacitor. The other pole of the first capacitor may be connected to the source side of the first semiconductor chip and another pole of the second capacitor may be connected to the drain side of the second semiconductor chip. In another example, each of the two capacitors may be connected in parallel to one of the semiconductor chips. In other words, one of the two capacitors, particularly the first capacitor may be connected in parallel to the first semiconductor chip. In other words, one pole of the first capacitor may be connected to the drain side of the first semiconductor chip and the other pole of the capacitor may be connected to the source side of the first semiconductor chip. Another one of the two capacitors, particularly, the second capacitor may be connected in parallel to the second semiconductor chip. In other words, one pole of the second capacitor may be connected to the drain side of the second semiconductor chip and the other pole of the capacitor may be connected to the source side of the second semiconductor chip. Two connected poles of the capacitors may be further connected to the drain side of the first semiconductor chip and to the source side of the second semiconductor chip. The other pole of the first capacitor connected to the source side of the first semiconductor chip may be further connected to the negative terminal of the power source. The other pole of the second capacitor connected to the drain side of the second semiconductor chip may be further connected to the positive terminal of the power source.

According to an example, the semiconductor chips and the one or more capacitors may be provided on a common printed circuit board.

The power semiconductor device comprising the semiconductor chips, and the one or more capacitors may be provided on a single printed circuit board, PCB. The first semiconductor chip may be positioned on the PCB in an orientation opposite to that of the second semiconductor chip. The two semiconductor chips can be arranged in such a way that the first semiconductor chip is flipped or rotated relative to the second semiconductor chip. Specifically, the first semiconductor chip may be positioned in the reverse direction relative to the second semiconductor chip. In other words, the two semiconductor chips may be arranged such that the first side of the first semiconductor chip is opposite of a functionally corresponding first side of the second semiconductor chip and similarly for the second sides. Functionally corresponding may mean that the first sides of the semiconductor chips have the same function, and the second sides of the semiconductor chips have the same function in their semiconductor chips. For example, the first sides may be drain sides and the second sides may be source sides, or the other way around. For example, the drain side of the first semiconductor chip and the source side of the second semiconductor chip may be arranged opposite of a source side of the first semiconductor and a drain side of the second semiconductor device. In another example, the one or more capacitors may be arranged between the two semiconductor chips on the PCB. Arranging the semiconductor chips and the one or more capacitors on a single PCB may provide advantages in terms of size, performance and/or reliability of the power semiconductor device.

According to an example, the power semiconductor device further may comprise at least one first integrated circuit for a gate connection and/or a control of pulse width modulation and a second integrated circuit for a gate connection, and wherein the integrated circuits may be provided on the printed circuit board, and the at least one first integrated circuit may be electrically connected to the first semiconductor chip electrically and the second integrated circuit is electrically connected to the second semiconductor chip.

The at least one first integrated circuit for a gate connection may be a gate driver circuit for a gate of the first semiconductor chip. The second integrated circuit for a gate connection may be a gate driver circuit of the second semiconductor chip. The control of pulse width modulation, PWM, may be a circuit providing PWM signals for the first and second integrated circuits. The first integrated circuit, the second integrated circuit and the control of PWM may be arranged on the PCB, on which the semiconductor chips are arranged. In an example, the semiconductor chips may be arranged in between the first integrated circuit and the second integrated circuit on the PCB. The control of PWM may be arranged next to the first integrated circuit or to the second integrated circuit. The PCB of the power semiconductor device may comprise a connection socket to connect the power semiconductor device to other power semiconductor devices.

According to an example, the power semiconductor device further may comprise a first electrically conductive substrate for an output signal of the inverter system, and wherein the first electrically conductive substrate may be electrically connected to the drain side of the first semiconductor chip and the source side of the second semiconductor chip.

The first electrically conductive substrate may be electrically connected to the drain side of the first semiconductor chip and/or to the source side of the second semiconductor chip, as they are connected to one another. The output signal of the inverter system may be an AC signal. Accordingly, the first electrically conductive substrate may provide an AC output signal.

According to an example, the drain side of the first semiconductor chip and the source side of the second semiconductor chip may face the first electrically conductive substrate.

The first semiconductor chip and the second semiconductor chip may be arranged in such a way that the drain side of the first semiconductor chip and the source side of the second semiconductor chip are on the same side of the power semiconductor device. In other words, the drain side of the first semiconductor chip and the source side of the second semiconductor chip may face the first electrically conductive substrate.

According to an example, the power semiconductor device further may comprise a second electrically conductive substrate for a first input signal of the inverter system and a third electrically conductive substrate for a second input signal of the inverter system, and wherein the second electrically conductive substrate is electrically connected to the source side of the first semiconductor chip and the third electrically conductive substrate is electrically connected to the drain side of the second semiconductor chip.

The first and the second input signals of the inverter system may be DC signals. In an example, the second electrically conductive substrate may be a negative terminal of the DC input signal. In other words, the second electrically conductive substrate may be connected to the negative terminal of the power source. In another example, the third electrically conductive substrate may be a positive terminal of the DC input signal. In other words, the third electrically conductive substrate may be connected to the positive terminal of the power source. Accordingly, the source side of the first semiconductor chip may be connected to the negative terminal of the power source and the drain side of the second semiconductor chip may be connected to the positive terminal of the power source.

According to an example, the source side of the first semiconductor chip and the drain side of the second semiconductor chip may face the second electrically conductive substrate and/or the third electrically conductive substrate.

The first semiconductor chip and the second semiconductor chip may be arranged in a way that the source side of the first semiconductor chip and the drain side of the second semiconductor chip are on the same side (of the power semiconductor device). In other words, the source side of the first semiconductor chip and the drain side of the second semiconductor chip may face the second electrically conductive substrate and/or the third electrically conductive substrate. In an example, the source side of the first semiconductor chip may face the second electrically conductive substrate and the drain side of the second semiconductor chip may face the third electrically conductive substrate.

According to an example, the first electrically conductive substrate, the second electrically conductive substrate and/or the third electrically conductive substrate may be arranged substantially in parallel to one another.

The first electrically conductive substrate and the second electrically conductive substrate may be arranged substantially in parallel to one another. In other words, a distance between the first electrically conductive substrate and the second electrically conductive substrate may be constant along their two-dimensional extensions. The first electrically conductive substrate and the second electrically conductive substrate may be arranged in parallel to the third electrically conductive substrate. Accordingly, a distance between the first electrically conductive substrate and the third electrically conductive substrate may be constant along their two-dimensional extensions. In addition, a distance between the second electrically conductive substrate and the third electrically conductive substrate may be constant along their two-dimensional extensions. In an example, the first electrically conductive substrate and the drain side of the first semiconductor chip and the source side of the second semiconductor chip may be arranged in parallel to one another. Furthermore, the first electrically conductive substrate and the source side of the first semiconductor chip and the drain side of the second semiconductor chip may be arranged in parallel to one another. In another example, the second electrically conductive substrate and the source side of the first semiconductor chip and the drain side of the second semiconductor chip may be arranged in parallel to one another.. In another example, the third electrically conductive substrate and the source side of the first semiconductor chip and the drain side of the second semiconductor chip may be arranged in parallel to one another.

According to an example, the power semiconductor device may further comprise a first electrically non-conductive substrate arranged between the second electrically conductive substrate and the third electrically conductive substrate.

A space provided in between the parallel arrangement of the second and the third electrically conductive substrates may be at least filled partially with the first electrically non-conductive substrate. The first electrically non-conductive substrate's properties may provide insulation, preventing electrical interference between the second and third electrically conductive substrates. Meanwhile, the second electrically conductive substrate and the third electrically conductive substrate may enable electrical connectivity to the semiconductor chips. This layered approach may not only improve electrical reliability but also may contribute to better thermal management and device stability. In an example, the first electrically non-conductive substrate may be arranged between the second electrically conductive substrate and the third electrically conductive substrate only in the area in which the first semiconductor chip arranged. Thus, the electrical interference between the second and third electrically conductive substrates in the said area may be prevented.

According to an example, the power semiconductor device may comprise at least one heatsink thermally coupled to the two semiconductor chips.

The power semiconductor device may comprise two semiconductor chips and one heatsink, configured to provide a one-sided heat transfer path, wherein the two semiconductor chips may be thermally coupled to the one heatsink. The heat transfer path may comprise a route or sequence through which heat generated by one or both of the two semiconductor chips is transferred through the heatsink into the surrounding environment. The one-sided heat transfer path may comprise a route or sequence through which heat generated from only one side of the one or more semiconductor chips is transferred through the heatsink into the surrounding environment.

Generally, a heatsink may be a device that transfers heat from an electronic device, a mechanical device, or a process to a fluid medium. The fluid medium may be surrounding the heatsink and it may be a liquid coolant or air, for example. The body of the heatsink may be made from a heat-conducting material, such as a metal, particularly aluminum or copper. The body of the heatsink may comprise at least a base portion and a fin portion and may be of one-piece construction. In other words, the base portion and the fin portion are made from the same material and manufactured as a single, continuous part without any separate joints or connections. The base portion may be thermally connected to the parts of the device which are generating the heat, specifically the one or more semiconductor chips. The fin portion comprises a plurality of fins, which may be designed to maximize the surface area in contact with a fluid medium surrounding the fin portion. The plurality of fins may be in the form of pins, or pin fins, which extend from the base portion, allowing the fluid medium to flow between them and/or may be cylindrical, elliptical, or square in shape. The pin fins may for example be in the form of splayed fins, where the fins are angled or bent outward from the base portion. Alternatively, the plurality of fins may be in the form of plate fins, which are flat, thin structures attached to the base portion and extend from it. Additionally, the plurality of fins may be in the form of flexible fins, which are adjustable and can bend or move slightly to adapt to variations in fluid medium flow or mechanical stress. The heat transfer between the fin portion and the fluid medium may be a natural convection process, which requires free flow of the fluid medium over the body of the heatsink, and/or it may be an active convection process using a cooling device to flow the fluid medium over the body of the heatsink. Other words for heatsink may be radiator or heat dissipator. The heatsink may comprise a body for heat exchange with the two semiconductor chips of the power semiconductor device, the body comprising a base portion for attachment to the power semiconductor device and a fin portion adjacent to the base portion, the fin portion comprising a plurality of fins extended from the base portion. The heatsink in the power semiconductor device may be thermally coupled to the two semiconductor chips to transfer the heat generated by the two semiconductor chips to a surrounding environment. The heatsink may comprise one or more interior channels to enhance heat transfer from one or more semiconductor chips to the surrounding environment. In other words, these interior channels, extending inside the body of the heatsink, may be implemented to improve the cooling efficiency of the power semiconductor device. The one or more interior channels may for example but not only be extending straight, meandering, or braided inside the body. The one or more interior channels may for example be extended along the length, width, or height of the body. For example, there may be two or more interior channels connected to one another, thereby enhancing the heat transfer. More cooling capacity for cooling the one or more semiconductor chips may be provided inside the heatsink with the one or more interior channels extending inside the body. The at least one heatsink thermally coupled to the two semiconductor chips may being indicative of thermal attachment and/or thermal connection the at least one heatsink thermally coupled to the two semiconductor chips. In an example, the one or more interior channels may be at least partially filled with a coolant medium. The coolant medium may be a liquid or a gas.. In another example, the one or more interior channels may be at least partially filled with a phase change material. Generally, the phase change material, PCM, may be a substance that absorbs and releases heat during its phase transition between solid and liquid states, such as during melting or solidifying. PCM may also release heat during its phase transition between liquid and gas states. PCMs may have a phase change temperature at which they change from one phase to another. As PCMs absorb heat, their temperature may increase. When PCMs reach their phase change temperature, also known as their melting point, they may absorb a significant amount of heat at a nearly constant temperature until all the material has melted. This characteristic of PCMs may allow them to absorb significantly more heat compared to non-phase change materials. Accordingly, the one or more interior channels at least partially filled with the PCM may absorb significantly more heat from the one or more semiconductor chips compared to a solution with a natural or active convection process at the fin portion. More cooling capacity for cooling the one or more semiconductor chips may be provided inside the heatsink with the one or more interior channels extending inside the body, filled at least partially with the PMC. The PCM may for example include organic material like hydrocarbon, or inorganic material such as salt hydrate or hygroscopic substance. "At least partially filled" means that the one or more interior channels may not be completely empty but contain at least some amount of phase change material, or they may be completely filled with it.

According to an example, the semiconductor device may comprise a first heatsink and a second heatsink, and wherein the first heatsink is thermally coupled to the source side of the first semiconductor chip and the drain side of the second semiconductor chip, and the second heatsink is thermally coupled to the drain side of the first semiconductor and the source side of the second semiconductor device.

The power semiconductor device may comprise two semiconductor chips and two heatsinks. The two heatsinks may be thermally coupled to opposite sides of the two semiconductor chips, configured to provide a double-sided heat transfer path. The first heatsink may be thermally coupled to one side of the two semiconductor chips, particularly, to the source side of the first semiconductor chip and the drain side of the second semiconductor chip. The second heatsink may be thermally coupled to the other side of the two semiconductor chips, particularly, to the drain side of the first semiconductor chip and the source side of the second semiconductor chip. The first and the second heatsinks may be thermally coupled to opposite sides of the two semiconductor chips. In other words, the first and the second heatsinks arranged in opposite directions to one another or in such a way that a direction along height of plurality of fins of the first heatsink is transverse to a direction along height of plurality of fins of the second heatsink. The double-sided heat transfer path may comprise two routes or sequences through which heat generated from two sides of the two semiconductor chips is transferred through the two heatsinks into the surrounding environment of the bodies of the first and the second heatsinks. The two routes or sequences of the double-sided heat transfer path may be parallel. Thus, more cooling capacity for cooling the one or more semiconductor chips may be provided by using the first and the second heatsinks thermally coupled to opposite sides of the one or more semiconductor chips. In an example, the first electrically conductive substrate may be arranged in between the two semiconductor chips and the second heatsink. Furthermore, the second and the third electrically conductive substrates may be arranged in between the two semiconductor chips and the first heatsink. In another example, the power semiconductor device may comprise a thermally conductive spacer arranged between one of the two heatsinks and a side of the two semiconductor chips. In another example, a second electrically non-conductive substrate may be arranged between the second electrically conductive substrate and the first heatsink. Additionally, a third electrically non-conductive substrate may be arranged between the first electrically conductive substrate and the second heatsink.

According to a second aspect, there may be provided an electric vehicle comprising an electric motor, a power source, and an inverter system electrically connecting the electric motor with the power source, the inverter system comprising at least one power semiconductor device of any one of the previous claims.

In particular, the vehicle may comprise two or more power semiconductor devices of the second aspect. The vehicle may comprise two or more power semiconductor devices of the second aspect and one or more heatsinks of the first aspect.

According to an example, the inverter system may comprise six power semiconductor devices electrically connected to one another in parallel.

The six power semiconductor devices of the inverter system may provide a six-phase configuration for the electric vehicle. Each of the six power semiconductor devices may be provided as one or more power semiconductor units connecting to one another in parallel. In an example, each of the six power semiconductor devices may be provided as one power semiconductor unit, connecting to one another in parallel. The power semiconductor unit may be arranged in a cuboid shape. One side of the power semiconductor unit may comprise one or two input terminals while the opposite side may comprise an output terminal. The at least one input terminal and the output terminal of the power semiconductor unit may be the same as the input terminals and the output terminal of the inverter system. The parallel connection of multiple power semiconductor devices may provide flexibility in configuration and may simplify replacement of faulty units. The flexible configuration of the power semiconductor units may be a linear or a circular arrangement. In a linear arrangement the power semiconductor units may be arranged adj acent to another one, whereas in a circular arrangement the power semiconductor units may be arranged such that the input and/or output terminals form a circle. In other words, in the circular arrangement the side of the input terminals and/or the side of the output terminal of the power semiconductor units are arranged on a circle.

These and other aspects of the present disclosure will become apparent from and elucidated with reference to the examples described hereinafter.

### BRIEF DESCRIPTION OF DRAWINGS

Examples of the disclosure will be described in the following with reference to the following drawings.
- Figure 1: shows a cross-sectional view of an example of a power semiconductor device;
- Figure 2: shows an example of an equivalent circuit of the power semiconductor device of Fig. 1;
- Figure 3: shows different arrangement examples of a plurality of power semiconductor units; and
- Figure 4: shows a schematic illustration of an electric vehicle.

### DETAILED DESCRIPTION

The Figures are merely schematic representations and serve only to illustrate examples of the disclosure. Identical or equivalent elements are in principle provided with the same reference signs.

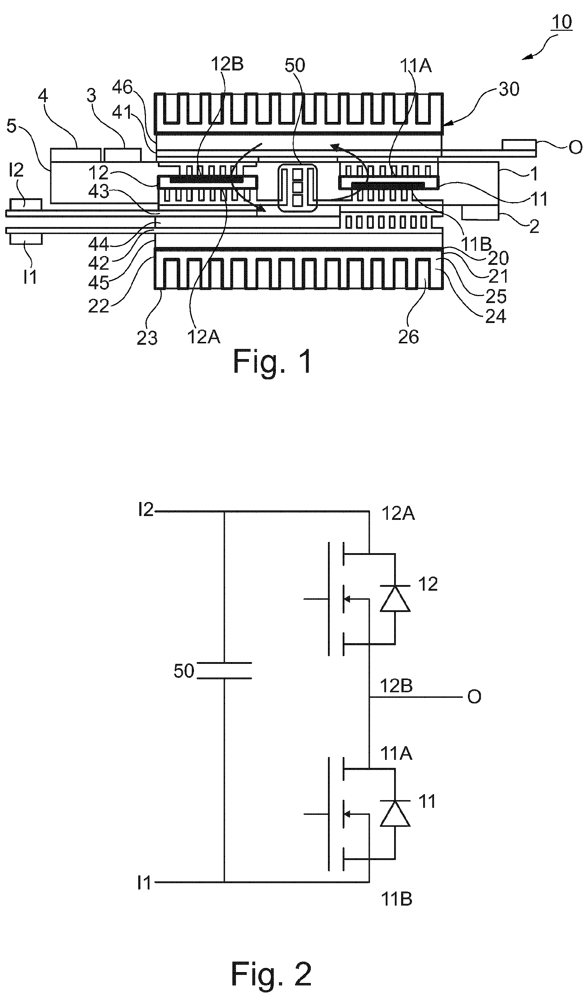

Figure 1 shows an example of a power semiconductor device 10. The power semiconductor device 10 comprises a first semiconductor chip 11, a second semiconductor chip 12, a first heatsink 20, a second heatsink 30 and a capacitor 50. The two semiconductor chips may be arranged such that the functionally equal or corresponding same sides of the both semiconductor chips 11, 12 are on opposite side to one another opposite of one another. The two semiconductor chips, 11 and 12, can be arranged in such a way that the first semiconductor chip 11 is flipped or rotated relative to the second semiconductor chip 12. In other words, the two semiconductor chips 11, 12 may be arranged such that the first side of the first semiconductor chip 11 is opposite of a functionally corresponding first side of the second semiconductor chip 12 and similarly for the second sides of the semiconductor chips 11, 12. Functionally corresponding may mean that the first sides of the semiconductor chips 11,12 have the same function, and the second sides of the semiconductor chips 11, 12 have the same function in their semiconductor chips 11, 12. For example, the first sides may be source sides 11B, 12B and the second sides may be drain sides 11A, 12A, or the other way around. The capacitor 50 is arranged between the first semiconductor chip 11 and the second semiconductor chip 12. The capacitor 50 is electrically connected to the first semiconductor chip 11 and the second semiconductor chip 12. The first heatsink 20 and the second heatsink 30 are thermally coupled to the semiconductor chips 11, 12. In particular, the first heatsink 20 and the second heatsink 30 are thermally coupled to opposite sides of the semiconductor chips 11, 12.

The first heatsink 20 and the second heatsink 30 are thermally coupled to the semiconductor chips 11, 12. The first side, namely the source side 11B of the first power semiconductor chip 11 and the second side, namely the drain side 12A of the second semiconductor chip 12 are arranged at the first heatsink 20. Thus, the first heatsink 20 absorbs the heat from the semiconductor chips 11, 12, creating a first heat transfer path. The second side, namely the drain side 11A of the first power semiconductor chip 11 and the first side, namely the source side 12B of the second semiconductor chip 12 are arranged at the second heatsink 30. Thus, the second heatsink 30 absorbs the heat from the semiconductor chips 11, 12, creating a second heat transfer path. Both heatsinks 20, 30 comprise one or more interior channels 24 for cooling the heatsinks 20, 30, wherein the one or more interior channels 24 extend inside the body 21. These channels 24 inside the bodies 21 of the heatsinks 20, 30 may be at least partially filled with a PCM 25. A fluid medium 26 surrounds the heatsinks 20, 30, particularly the fin portion 23. On the one hand, the fluid medium 26 may be naturally or actively conveyed to the fin portion 23 for naturally or actively convection cooling of the heatsinks 20, 30 and thereby the semiconductor chips 11, 12. On the other hand, the channels filled with PCM 25 may be used to additionally cool the semiconductor chips 11, 12, specifically during peak loads of the power semiconductor device 10. Alternatively, or additionally, an actively cooled cooling fluid may be flowing through the channels 24 for actively cooling the semiconductor chips 11, 12.

Additionally, the power semiconductor device 10 comprises substrate layers arranged between the first heatsink 20 and a one side of the semiconductor chip 11, 12 and between the second heatsink 30 and another side of the semiconductor chips 11, 12. The substrate layers between the first heatsink 20 and one side of the semiconductor chip 11, 12 comprise a second electrically non-conductive substrate 45, a second electrically conductive substrate 42, a first electrically non-conductive substrate 44, and a third electrically conductive substrate 43. The second electrically conductive substrate 42 is arranged in between the first semiconductor chip 11 and the first heatsink 20. The second electrically non-conductive substrate 45 is arranged between the first heatsink 20 and the second electrically conductive substrate 42. The first electrically non-conductive substrate 44 is arranged between the second electrically conductive substrate 42 and the third electrically conductive substrate 43. The third electrically conductive substrate 43 is arranged in between the second semiconductor chip 12 and the first electrically non-conductive substrate 44. The substrate layers between the second heatsink 30 and one side of the semiconductor chip 11, 12 comprise a first electrically conductive substrate 41 and a third electrically non-conductive substrate 46. The first electrically conductive substrate 41 is arranged in between the second heatsink 30 and the semiconductor chips 11, 12. The third electrically non-conductive substrate 46 is arranged between the first electrically conductive substrate 41 and the second heatsink 30.

The first electrically conductive substrate 41 is connected directly to the drain side 11A of the first semiconductor chip 11 and to the source side 12B of the second semiconductor chip 12. In this example, the second electrically conductive substrate 42 is connected to the source side 11B of the first semiconductor chip 11 and the third electrically conductive substrate 43 is connected to the drain side 12A of the second semiconductor chip 12.

In an example, first and second input terminals I1, I2 of the inverter system of the power semiconductor device 10 are DC input terminals and an output terminal O of the inverter system 70 is an AC output terminal. The power semiconductor device 10 may further comprise a first integrated circuit 2, a second integrated circuit 3 for gate connections and a control of pulse width modulation 4, PWM, arranged on a common printed circuit board 1, PCB. The PCB 1 of the power semiconductor device 10 may comprise a connection socket 5 to connect the power semiconductor device 10 to other power semiconductor devices.

Figure 2 shows an example of an equivalent circuit of the power semiconductor device 10 of Fig. 1, in particular, of a half bridge inverter. The inverter 70 comprises two semiconductor chips 11, 12 connected to one another and a capacitor 50, wherein the capacitor 50 is connected to the semiconductor chips 11, 12 in parallel. The semiconductor chips 11, 12 in this example are MOSFETs. Input terminals I1, I2 of the inverter circuit 70 may be connected to the DC power source and may provide the AC signal to the output terminal O. The output terminal O of the inverter system 70 may be connected to the first electrically conductive substrate 41. A first input terminal I1 of the inverter system 70 is connected to the second electrically conductive substrate 42 and a second input terminal I2 of the inverter system 70 is connected to the third electrically conductive substrate 43. The first input terminal I1 may be a negative terminal of the DC input signal and the second input terminal I2 may be a positive terminal of the DC input signal.

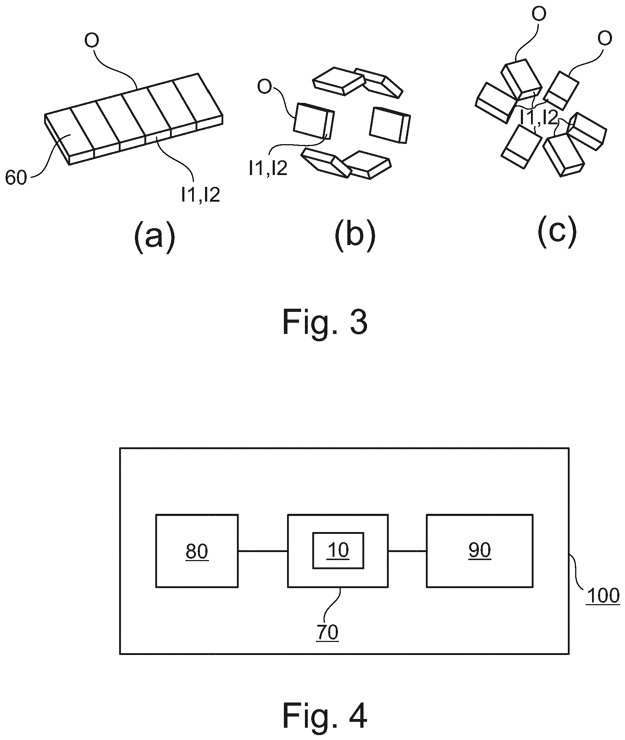

Figures 3a to 3c show different arrangement examples of configurations of six power semiconductor units 60. Each of the six power semiconductor units 60 comprise at least one power semiconductor device 10. The six power semiconductor units 60 are connected to one another in parallel. The power semiconductor units 60 are exemplary configured with a cuboid shape. One side of the power semiconductor unit 60 comprises input terminals 11, I2 and another side being opposite to the input terminals 11, I2 comprises an output terminal O. The six power semiconductor units 60 connected in parallel provide a flexible configuration. This flexible configuration eases replacement of a defect power semiconductor unit 60. The arrangement of the power semiconductor units 60 may be linear (Fig. 3a) or it may be circular (Fig. 3b, 3c). In the linear configuration, the power semiconductor units 60 may be arranged adjacent to one another. In the circular configuration, the power semiconductor unit 60 may be arranged in a way that the side of the input terminals I1, I2 and/or the side of the output terminal O of the power semiconductor units 60 are arranged on the circumference of a circle.

Figure 4 shows an electric vehicle 100 comprising an electric motor 90, an inverter system 70, a power source 80 and a power semiconductor device 10. The electric motor 90 is electrically connected to the power source 80 via the inverter system 70. Specifically, the inverter system 70 may be converting a DC current supplied by the power source 80 to an AC current supplied to the electric motor 90 for propulsion of the electric vehicle 100. The inverter system 70 comprises at least one power semiconductor device 10, as described herein.

As used herein, the phrase "at least one," in reference to a list of one or more entities should be understood to mean at least one entity selected from any one or more of the entities in the list of entities, but not necessarily including at least one of each and every entity specifically listed within the list of entities and not excluding any combinations of entities in the list of entities. This definition also allows that entities may optionally be present other than the entities specifically identified within the list of entities to which the phrase "at least one" refers, whether related or unrelated to those entities specifically identified. Thus, as a nonlimiting example, "at least one of A and B" (or, equivalently, "at least one of A or B," or, equivalently "at least one of A and/or B") may refer, in one example, to at least one, optionally including more than one, A, with no B present (and optionally including entities other than B); in another example, to at least one, optionally including more than one, B, with no A present (and optionally including entities other than A); in yet another example, to at least one, optionally including more than one, A, and at least one, optionally including more than one, B (and optionally including other entities). In other words, the phrases "at least one," "one or more," and "and/or" are open-ended expressions that are both conjunctive and disjunctive in operation. For example, each of the expressions "at least one of A, B, and C," "at least one of A, B, or C," "one or more of A, B, and C," "one or more of A, B, or C," and "A, B, and/or C" may mean A alone, B alone, C alone, A and B together, A and C together, B and C together, A, B, and C together, and optionally any of the above in combination with at least one other entity.

Other variations to the disclosed examples can be understood and effected by those skilled in the art in practicing the claimed disclosure, from the study of the drawings, the disclosure, and the appended claims. In the claims the word "comprising" does not exclude other elements or steps and the indefinite article "a" or "an" does not exclude a plurality. The mere fact that certain measures are recited in mutually different dependent claims does not indicate that a combination of these measures cannot be used to advantage. Any reference signs in the claims should not be construed as limiting the scope of the claims.

### LIST OF REFERENCE SIGNS

- 1: printed circuit board
- 2: first integrated circuit
- 3: second integrated circuit
- 4: control of pulse width modulation
- 5: socket
- 10: power semiconductor device
- 11: first semiconductor chip
- 11A: drain side of the first semiconductor chip
- 11B: source side of the first semiconductor chip
- 12: second semiconductor chip
- 12A: drain side of the second semiconductor chip
- 12B: source side of the second semiconductor chip
- 20: first heatsink
- 21: body
- 22: base portion
- 23: fin portion
- 24: interior channel
- 25: phase change material
- 26: fluid medium
- 30: second heatsink
- 41: first electrically conductive substrate
- 42: second electrically conductive substrate
- 43: third electrically conductive substrate
- 44: first electrically non-conductive substrate
- 45: second electrically non-conductive substrate
- 46: third electrically non-conductive substrate
- 50: capacitor
- 60: power semiconductor unit
- 70: inverter system
- 80: power source
- 90: electric motor
- 100: electric vehicle
- O: output terminal of the inverter system
- 11: first input terminal of the inverter system
- I2: second input terminal of the inverter system

## Claims

1. A power semiconductor device (10) for an inverter system (70) of an electric vehicle (100), the power semiconductor device (10) comprising a first semiconductor chip (11) and a second semiconductor chip (12),
wherein a drain side (11A) of the first semiconductor chip (11) is electrically connected to a source side (12B) of the second semiconductor chip (12), and
wherein the drain side (11A) of the first semiconductor chip (11) and the source side (12B) of the second semiconductor chip (12) are arranged opposite of a source side (11B) of the first semiconductor chip (11) and a drain side (12A) of the second semiconductor chip (12).

2. The power semiconductor device (10) of claim 1, wherein the power semiconductor device (10) further comprises one or more capacitors (50) electrically connected in parallel to both semiconductor chips (11, 12).

3. The power semiconductor device (10) of claim 2, wherein the one or more capacitors (50) are electrically connected between the source side (11B) of the first semiconductor chip (11) and the drain side (12A) of the second semiconductor chip (12).

4. The power semiconductor device (10) of claim 2 or 3, wherein the semiconductor chips (11, 12) and the one or more capacitors (50) are provided on a common printed circuit board (1).

5. The power semiconductor device (10) of claim 4, wherein the power semiconductor device (10) further comprises at least one first integrated circuit (2) for a gate connection and/or a control of pulse width modulation (4) and a second integrated circuit (3) for a gate connection, and wherein the integrated circuits (2, 3) are provided on the printed circuit board (1), and the at least one first integrated circuit (2) is electrically connected to the first semiconductor chip (11) electrically and the second integrated (3) circuit is electrically connected to the second semiconductor chip (12).

6. The power semiconductor device (10) of any one of the previous claims, wherein the power semiconductor device (10) further comprises a first electrically conductive substrate (41) for an output signal of the inverter system (70), and wherein the first electrically conductive substrate (41) is electrically connected to the drain side (11A) of the first semiconductor chip (11) and the source side (12B) of the second semiconductor chip (12).

7. The power semiconductor device (10) of claim 6, wherein the drain side (11A) of the first semiconductor chip (11) and the source side (12B) of the second semiconductor chip (12) face the first electrically conductive substrate (41).

8. The power semiconductor device (10) of claim 6 or 7, wherein the power semiconductor device (10) further comprises a second electrically conductive substrate (42) for a first input signal of the inverter system (70) and a third electrically conductive substrate (43) for a second input signal of the inverter system (70), and wherein the second electrically conductive substrate (42) is electrically connected to the source side (11B) of the first semiconductor chip (11) and the third electrically conductive substrate (43) is electrically connected to the drain side (12A) of the second semiconductor chip (12).

9. The power semiconductor device (10) of claim 8, wherein the source side (11B) of the first semiconductor chip (11) and the drain side (12A) of the second semiconductor chip (12) face the second electrically conductive substrate (42) and/or the third electrically conductive substrate (43).

10. The power semiconductor device (10) of claim 8 or 9, wherein the first electrically conductive substrate (41), the second electrically conductive substrate (42) and/or the third electrically conductive substrate (43) are arranged substantially in parallel to one another.

11. The power semiconductor device (10) of any one of claims 8 to 10, wherein the power semiconductor device (10) further comprises a first electrically non-conductive substrate (44) arranged between the second electrically conductive substrate (42) and the third electrically conductive substrate (43).

12. The power semiconductor device (10) of any one of the previous claims, wherein the power semiconductor device (10) comprises at least one heatsink (20) thermally coupled to the two semiconductor chips (11, 12).

13. The power semiconductor device (10) of claim 12, wherein the power semiconductor device (10) comprises a first heatsink (20) and a second heatsink (30), and wherein the first heatsink (20) is thermally coupled to the source side (11B) of the first semiconductor chip (11) and the drain side (12A) of the second semiconductor chip (12), and the second heatsink (30) is thermally coupled to the drain side (11A) of the first semiconductor chip (11) and the source side (12B) of the second semiconductor chip (12).

14. An electric vehicle (100) comprising an electric motor (90), a power source (80), and an inverter system (70) electrically connecting the electric motor (90) with the power source (80), the inverter system (70) comprising at least one power semiconductor device (10) of any one of the previous claims.

15. The electric vehicle (100) of claim 14, wherein the inverter system (70) comprises six power semiconductor devices (10) electrically connected to one another in parallel.
